# EUROPEAN PATENT APPLICATION

(11) **EP 1 909 550 A1**
(43) Date of publication of application: **09.04.2008**
(21) Application number: 06020884.0
(22) Date of filing: 04.10.2006
(51) Int. Cl.: H05K 9/00

(54) **Supporting structure and display device using the same**

(71) Applicant: BenQ Corporation, Gueishan T'ao yuan 333 (TW)
(72) Inventor: Kuan, Hsin-Pao No. 10, 2nd Neighborhood, Taoyuan County 328 Taiwan (CN); Wang, Pai-Te, Miaoli City Miaoli County 360 Taiwan (CN); Chen, Shih-Pin, Taoyuan City Taoyuan County 330 Taiwan (CN)
(74) Representative: Hager, Thomas Johannes

(57) **Abstract**

A supporting structure and a display device using the same are provided. The supporting structure enables the display device to have low electro-magnetic interference (EMI). The display device has a display screen and the supporting structure. The supporting structure comprises a base, a low impedance stand and a high impedance stand. The low impedance stand is mechanically and electrically connected to the base. The high impedance stand is mechanically connected to the base, but electrically isolated from the base.

## Description

This application incorporates by reference of Taiwan application Serial No. 95127316, filed July 26, 2006, the subject matter of which is incorporated herein by reference.

### BACKGROUND OF THE INVENTION

### Field of the Invention

The invention relates in general to a supporting structure and a display device using the same, and more particularly to a supporting structure and a display device using the same capable of reducing the electro-magnetic interference (EMI) of the display device.

### Description of the Related Art

Generally speaking, the display device currently on the market, including the cathode ray tube (CRT) display device and the liquid crystal display (LCD) device, will emit electro-magnetic radiation and becomes a source of electro-magnetic interference (EMI). Besides, the electro-magnetic radiation emitted by the display device may be harmful to humans, therefore a number of international electro-magnetic radiation standards are applied to the display device so as to confine the amount of the electro-magnetic radiation emitted thereby. Thus, before a display device is on the market, the display device must pass the EMI test first to assure that the electro-magnetic radiation of the display device falls within a predetermined range.

Along with the maturity in the technology of display device, several varieties of large-sized display devices are now available in the market.
Since a large-sized display device is larger and heavier than an ordinary one, the display device needs to have a larger and stronger supporting structure to support the display screen. However, if the supporting structure is made from metal, mutual inductance effect will occur between the metallic supporting structure and the display screen, and after the supporting structure receives the electro-magnetic wave emitted by the display screen, the supporting structure will emit more electro-magnetic noises. Consequently, the overall electro-magnetic radiation emitted by the display device will be over the permitted radiation level, and the display device will not be able to pass the EMI test.

### SUMMARY OF THE INVENTION

It is therefore an object of the invention to provide a supporting structure and a display device using the same for effectively reducing the electro-magnetic radiation of the supporting structure and enabling the display device to have low electro-magnetic interference.

The invention achieves the above-identified object by providing a supporting structure enabling the display device to have low electro-magnetic interference. The display device has a display screen and a supporting structure. The supporting structure comprises a base, a low impedance stand and a high impedance stand. The low impedance stand is mechanically and electrically connected to the base. The high impedance stand is mechanically connected to the base, but electrically isolated from the base.

The invention achieves another object by providing a display device with low electro-magnetic interference. The display device comprises a display screen and a supporting structure. The supporting structure is for supporting the display screen. The supporting structure comprises a base, a low impedance stand and a high impedance stand. The low impedance stand is mechanically and electrically connected to the base. The high impedance stand is mechanically connected to the base, but electrically isolated from the base.

Other objects, features, and advantages of the invention will become apparent from the following detailed description of the preferred but non-limiting embodiments. The following description is made with reference to the accompanying drawings.

### BRIEF DESCRIPTION OF THE DRAWINGS

FIG. 1 is a 3-D perspective of a display device according to a preferred embodiment of the invention;

FIG. 2A is a 3-D perspective of a low impedance stand of FIG. 1;

FIG. 2B is a 3-D perspective of the low impedance stand of FIG. 2A viewed from another angle; and

FIG. 3 is a 3-D perspective of a high impedance stand of FIG. 1.

### DETAILED DESCRIPTION OF THE INVENTION

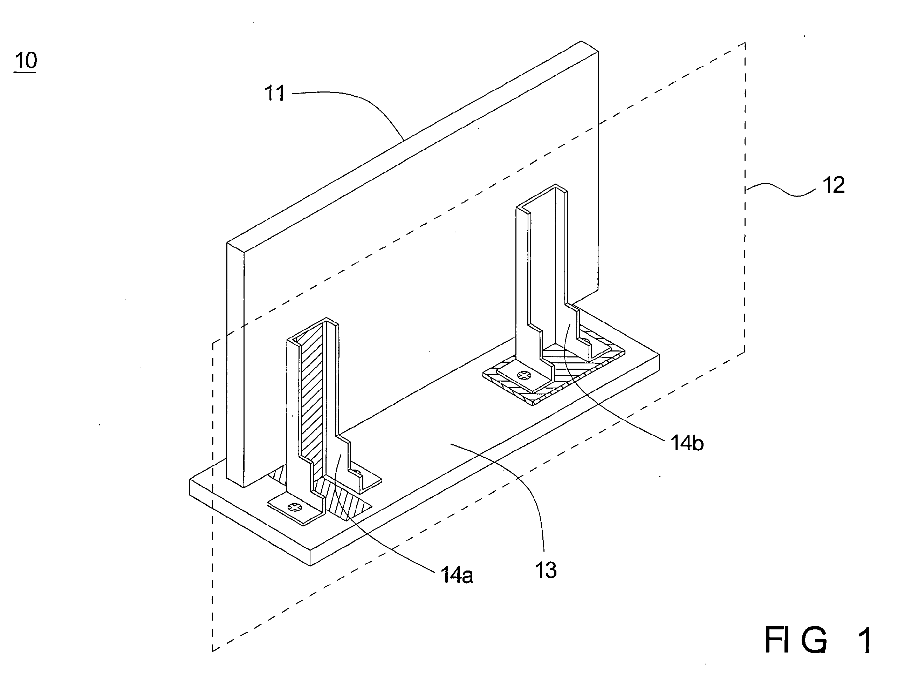

Referring to FIG. 1, a 3-D perspective of a display device according to a preferred embodiment of the invention is shown. The display device 10 comprises a display screen 11 and a supporting structure 12. The supporting structure 12 is for supporting the display screen 11. The supporting structure 12 comprises a base 13, a low impedance stand 14a and a high impedance stand 14b. The low impedance stand 14a is mechanically and electrically connected to the base 13. The high impedance stand 14b is mechanically connected to the base 13, but electrically isolated from the base 13.

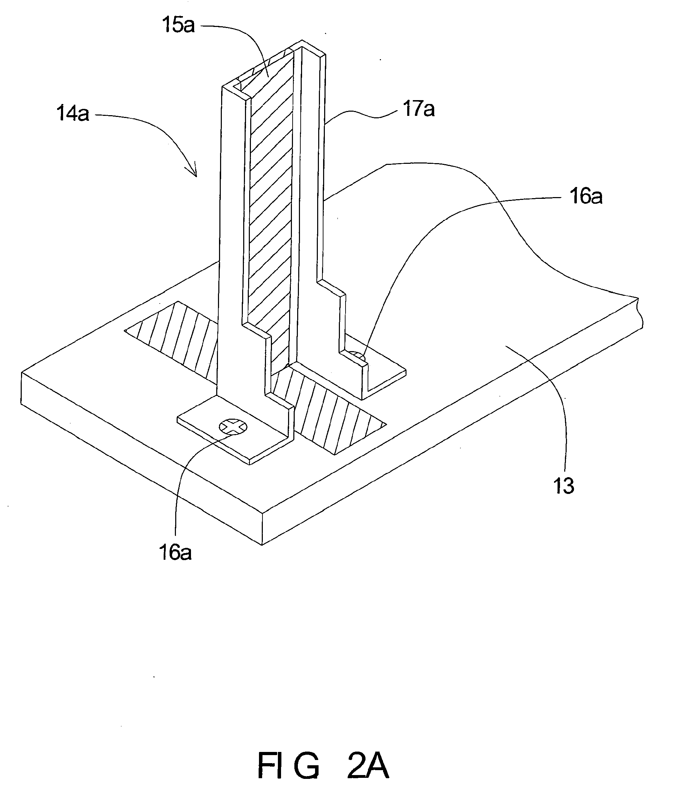

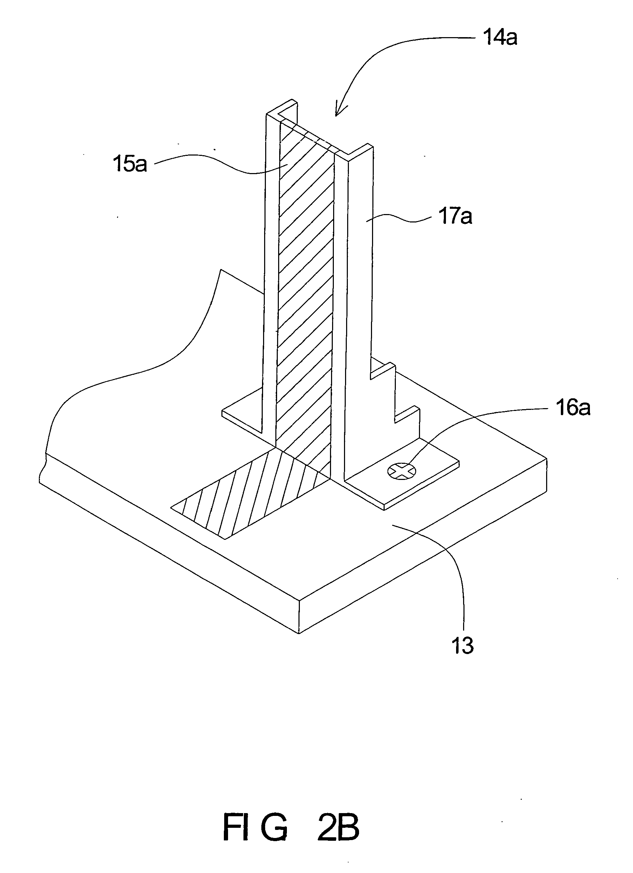

Referring to both FIG. 2A and 2B. FIG. 2A is a 3-D perspective of a low impedance stand of FIG. 1. FIG. 2B is a 3-D perspective of the low impedance stand of FIG. 2A viewed from another angle. The low impedance stand 14a comprises a conductive material 15a and a first stand body 17a. The first stand body 17a is exemplified by a metallic material. The conductive material 15a is exemplified by a conductive copper foil. The conductive material 15a at least covers part of the surface of the first stand body 17a. The first stand body 17a is electrically connected to the base 13 via the conductive material 15a. The first stand body 17a is mechanically connected to the base 13 via at least a conductive screw 16a. Thus, the conductive impedance between the low impedance stand 14a and the base 13 is reduced.

Preferably, the surface of the first stand body 17a is coated with an anti-rust material (not illustrated in the diagram). Preferably, the conductive material 15a is bar-shaped, and part of the conductive material 15a is pasted on the base 13 for enabling the conductive material 15a to be electrically connected to the base 13. Since the anti-rust material coated on the surface of the first stand body 17a will increase the conductive impedance of the first stand body 17a, the present embodiment of the invention reduces the overall impedance of the low impedance stand 14a by adhering the conductive material 15a on the base 13.

The way of fixing the low impedance stand 14a onto the base 13 is exemplified below. At first, at least a conductive screw 16a is used to screw the first stand body 17a onto the base 13. Next, a bar-shaped conductive material 15a is adhered on both the inside and the outside of the first stand body 17a, and the two ends of the conductive material 15a are adhered onto the base 13. The above adhering method is easy and fast to apply, and is labor- and cost-saving.

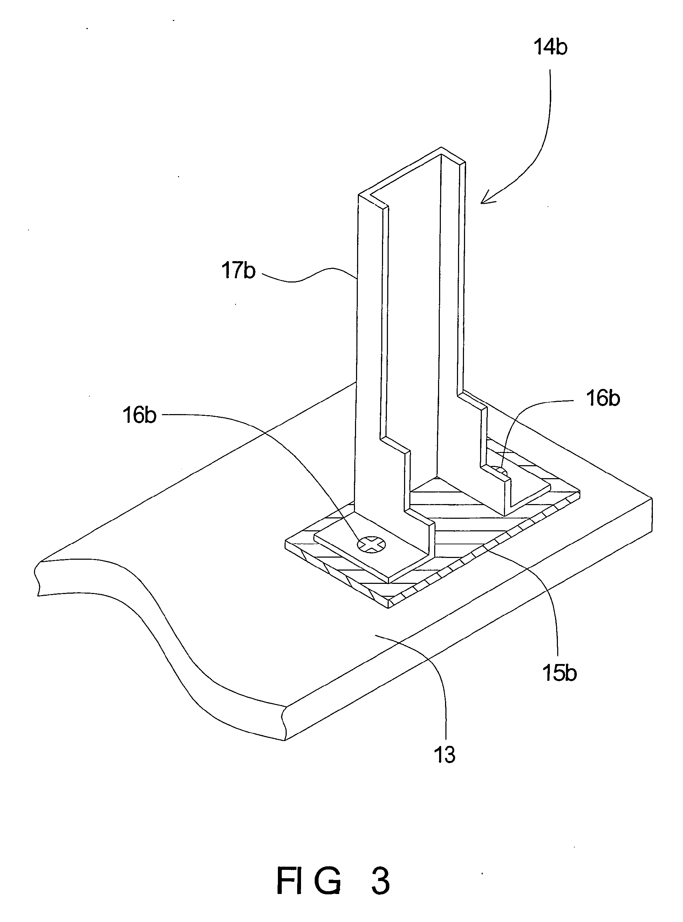

Referring to FIG. 3, a 3-D perspective of a high impedance stand of FIG. 1 is shown. The high impedance stand 14b comprises a insulating material 15b and a second stand body 17b. The second stand body 17b is exemplified by a metallic material. The insulating material 15b is exemplified by an insulating tape. At least, part of the insulating material 15b is disposed between the second stand body 17b and the base 13. The second stand body 17b is mechanically connected to the base 13 via at least an insulating screw 16b but is electrically isolated from the base 13 via the insulating material 15b. Thus, the conductive impedance between the high impedance stand 14b and the base 13 is increased.

Preferably, the surface of the second stand body 17b is coated with an anti-rust material. The anti-rust material increases the conductive impedance of the second stand body 17b. Since the anti-rust material only slightly increases the conductive impedance and is unable to electrically isolate the second stand body 17b from the base 13 completely, the second stand body 17b still needs to be disposed on the insulating material 15b. Preferably, the insulating material 15b is a plate and the size of the insulating material 15b is large enough to eclectically isolate the second stand body 17b from the base 13 completely.

The way of fixing the high impedance stand 14b onto the base 13 is exemplified below. At first, a plate-shaped insulating material 15b is directly adhered onto the surface of the base 13. Next, at least an insulating screw 16b is used to screw the second stand body 17b onto the base 13. The above adhering method is easy and fast to apply, and is labor- and cost-saving.

Besides, the base 13 of the present embodiment of the invention is exemplified by a metallic plate electrically connected to a ground plane (not illustrated in the diagram). The anti-rust material can be coated on the surface of the base 13 to prolong the lifespan of the metallic members including the first stand body 17a, the second stand body 17b and the base 13.

The supporting structure and the display device using the same disclosed in the above preferred embodiment have the following advantages. After the conductive impedance between the low impedance stand 14a and the base 13 is reduced, and that between the high impedance stand 14b and the base 13 is increased, the path of the ground loop of the supporting structure 12 is different from the conventional path of the ground loop of the display device, and both the amount and the direction of the electro-magnetic radiation of the supporting structure 12 are changed accordingly. Therefore, less electro-magnetic radiation will be emitted when mutual inductance effect occurs between the supporting structure 12 and the display screen 11. Consequently, the amount and direction of the overall radiation of the display device 10 are changed, and the display device 10 is provided with low electro-magnetic interference.

The conductive material 15a and the insulating material 15b are easy and cheap to obtain, so the electro-magnetic interference of the display device 10 can be achieved without significantly increasing the manufacturing cost. Moreover, the manufacturing process of the present embodiment of the invention can be easily achieved by slightly modifying the original manufacturing process. That is, the step of adhering the conductive material 15a onto the first stand body 17a and the base 13 and the step of adhering the insulating material 15b onto the base 13 are added to the original manufacturing process.

According to the supporting structure and the display device using the same disclosed in the preferred embodiment of the invention, with the use of low impedance stand and the high impedance stand, the display screen is electrically isolated from and disposed on the supporting structure of the invention, such that the display dievice is enabled to have low electro-magnetic interference and will not be failed in the EMI test. Meanwhile, the display device of the invention is cost-saving.

While the invention has been described by way of example and in terms of a preferred embodiment, it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A supporting structure enabling a display device to have low electro-magnetic interference (EMI), wherein the display device has a display screen and a supporting structure, the supporting structure comprising:
a base;
a low impedance stand mechanically and electrically connected to the base; and
a high impedance stand mechanically connected to the base, but electrically isolated from the base.

2. The supporting structure according to claim 1, wherein the low impedance stand comprises a conductive material and a first stand body, and the conductive material at least covers part of the surface of the first stand body electrically connected to the base via the conductive material for reducing the inductive impedance of the low impedance stand.

3. The supporting structure according to claim 1, wherein the high impedance stand comprises an insulating material and a second stand body, and at least part of the insulating material is disposed between the second stand body and the base, the high impedance stand is electrically isolated form the base via the insulating material for increasing the inductive impedance of the high impedance stand.

4. The supporting structure according to claim 1, wherein the supporting structure further comprises at least a conductive screw for screwing the low impedance stand onto the base.

5. The supporting structure according to claim 1, wherein the supporting structure further comprises at least an insulating screw for screwing the high impedance stand onto the base.

6. The supporting structure according to claim 1, wherein the base is a metallic plate electrically connected to a ground plane.

7. A display device with low electro-magnetic interference (EMI), comprising:
a display screen; and
a supporting structure for supporting the display screen, the supporting structure comprising:
a base;
a low impedance stand mechanically and electrically connected to the base; and
a high impedance stand mechanically connected to the base, but electrically isolated from the base.

8. The display device according to claim 7, wherein the low impedance stand comprises a conductive material and a first stand body, and the conductive material at least covers part of the surface of the first stand body, the first stand body is electrically connected to the base via the conductive material for reducing the conductive impedance of the low impedance stand.

9. The display device according to claim 7, wherein-the high impedance stand comprises an insulating material and a second stand body, at least part of the insulating material is disposed between the second stand body and the base, the high impedance stand is electrically isolated from the base via the insulating material for increasing the conductive impedance of the high impedance stand.

10. The display device according to claim 7, wherein the supporting structure further comprises at least a conductive screw for screwing the low impedance stand onto the base.

11. The display device according to claim 7, wherein the supporting structure further comprises at least an insulating screw for screwing the high impedance stand onto the base.

12. The display device according to claim 7, wherein the base is a metallic plate electrically connected to a ground plane.
